# EUROPÄISCHE PATENTANMELDUNG

(11) **EP 1 577 676 A1**
(43) Veröffentlichungstag der Anmeldung: **21.09.2005**
(21) Anmeldenummer: 05450050.9
(22) Anmeldetag: 15.03.2005
(51) Int. Cl.: G01R 31/30, G01R 31/28, G01R 1/067

(54) **Verfahren und Schaltung zum Schutz von Prüfkontakten bei der Hochstrom-Messung von Halbleiter-Bauelementen**

(30) Priorität: 15.03.2004 AT 4532004
(71) Anmelder: T.I.P.S. messtechnik GmbH, 9500 Villach (AT)
(72) Erfinder: Gaggl, Rainer, 9500 Villach (AT)
(74) Vertreter: Beer, Manfred

(57) **Zusammenfassung**

Zum Begrenzen des Stroms beim Hochstromprüfen von Halbleiterbauelementen mit Prüfnadeln wird jeder Nadel eine Schaltung vorgeordnet, die im Bereich zulässiger Ströme niederohmig und oberhalb eines vorgegebenen Grenzstroms hochohmig ist. Die Stromquelle, welche die Begrenzung in der elektrischen Zuleitung zur Prüfspitze vornimmt, ist von der Spannungsversorgung der Stromquelle selbst galvanisch getrennt.

## Beschreibung

Die Erfindung bezieht sich auf ein Verfahren und auf eine Messvorrichtung zur Hochstromprüfung von Halbleiterbauelementen (in weiterer Folge mit Chip bezeichnet). Die zu prüfenden Chips können noch auf Scheiben des Halbleitermaterials (in weiterer Folge mit Halbleiterscheibe bezeichnet) vorliegen. Die zu prüfenden Chips können auch bereits aus den Halbleiterscheiben herausgetrennte, einzelne Chips sein.

Zum elektrischen Prüfen von Halbleiter-Bauelementen, insbesondere Leistungshalbleitern, wie bipolaren Leistungstransistoren, MOS-FET's, Leistungsdioden und IGBT's, werden diese durch Anlegen eines hohen Messstromes (typischerweise im Bereich von etwa 2 A bis 200 A) auf ihre Hochstromtauglichkeit geprüft.

Dabei werden die Chips, die noch nicht in ihr Gehäuse eingebaut sind und sich beispielsweise aneinanderliegend (noch nicht vereinzelt) auf der Halbleiterscheibe befinden, über Prüfkontakte an den Kontaktflächen der Chipvorderseite elektrisch kontaktiert.

Das Kontaktieren geschieht typischerweise über eine so genannte Nadelkarte oder Prüfkarte (englisch: probe card), die aus einer geometrisch dem zu testenden Chip angepassten Anordnung von feinsten Prüfspitzen (englisch: probes) besteht. Die Nadelkarte ist mit dem Testsystem verbunden, das Strom- und Spannungsquellen sowie verschiedene elektrische Messinstrumente zur elektrischen Prüfung des Chip aufweist.

Insbesondere beim Prüfen von Hochstrom-Bauelementen aber auch bei anderen Halbleiterbauelementen, wie Mikroprozessoren, kann es durch zu hohe Prüfströme zur Überlastung einzelner Prüfspitzen und/oder von Kontaktstellen zwischen Prüfspitze und geprüftem Chip kommen. Diese Stromspitzen führen wegen der dabei auftretenden hohen Temperaturen in weiterer Folge zu Beschädigungen der Prüfspitzen und/oder des zu prüfenden Chip.

Derartige Überströme (Stromspitzen) können verschiedene Ursachen haben, als Beispiel werden angeführt :
1. Unsymmetrische Stromverteilung bei parallel geschalteten Prüfspitzen: Beim Messen von Strömen, die höher sind als die Strombelastbarkeit einer einzelnen Prüfspitze wird der Prüfstrom über zwei oder mehrere parallel geschaltete Prüfspitzen geführt. Im Idealfall teilt sich der Prüfstrom gleichmäßig auf die Prüfspitzen auf. In der Praxis treten jedoch, beispielsweise aufgrund von schlecht leitend Verschmutzungen (Oxidationen) an den Kontaktstellen, Unterschiede in den Kontaktwiderständen der einzelnen parallel geschalteten Prüfspitzen auf, die dann zu ungleicher Stromverteilung zwischen den Prüfspitzen und zu einer Überlastung einzelner Prüfspitzen führt.
2. Wird ein Chip geprüft, der beispielsweise einen Defekt aufweist, der zu einem Kurzschluss der Stromquelle führt, so wird der maximal fließende Prüfstrom durch die Strombegrenzung der Quelle bestimmt. Zu hoch eingestellte oder zu langsam reagierende Strombegrenzungen der Quellen können zur Überlastung der Prüfspitze führen.

Bislang wurde das Problem dadurch gelöst, dass defekte Prüfspitzen oder auch komplette Prüfkarten ausgetauscht wurden.

Ein weiterer Ansatz zum Vermeiden von Überströmen bei parallel geschalteten Prüfspitzen ist die Verwendung von in Serie zu den einzelnen Prüfspitzen geschalteten Widerständen zur Stromsymmetrierung. Diese sollten jedoch, um wirksam zu sein, wesentlich größer sein als die Variation der Kontaktwiderstände der einzelnen Prüfspitzen. Dies erhöht jedoch den Gesamtwiderstand des Messpfades. Dies ist insbesondere bei Hochstrommessungen unerwünscht.

Der Erfindung liegt die Aufgabe zu Grunde, ein Verfahren und eine Vorrichtung anzugeben, bei dem sich zu hohe Ströme durch einzelne Prüfspitzen vermeiden lassen, wobei sich die elektrischen Eigenschaften der Prüfanordnung - insbesondere Gesamtwiderstand und elektrische Isolation des Messpfades - im Bereich zulässiger Ströme nicht wesentlich ändern.

Gelöst wird die Erfindung mit den Merkmalen des Verfahrenshauptanspruches und soweit die Vorrichtung betroffen ist, mit den Merkmalen des Vorrichtungshauptanspruches.

Bevorzugte und vorteilhafte Ausgestaltungen der Erfindung sind Gegenstand der Unteransprüche.

Die Erfindung nutzt in einer bevorzugten Ausführungsform die Eigenschaft von MOS-FET- Transistoren, dass in Abhängigkeit von der Steuerspannung zwischen Gate und Source eine Sättigung des Source-Drain Stromes nahezu unabhängig von der an der Source-Drain Strecke anliegenden Spannung eintritt.

Analog haben die im Rahmen der Erfindung in einer Ausführungsform alternativ eingesetzten Bipolar-Transistoren die Eigenschaft der Sättigung des Ermitter-Kollektor Stromes in Abhängigkeit vom Basisstrom.

Im so genannten Durchlassbereich, entsprechend Strömen unter dem Sättigungsstrom, tritt an der Source-Drain Strecke bzw. Emitter-Kollektor Strecke ein nur geringer Spannungsabfall auf.

Zur Lösung der erfindungsgemäßen Aufgabe wird in einer bevorzugten Ausführungsform nun wenigstens ein MOS-FET-Transistor (oder ein bipolarer Transistor) in die Zuleitung zur Prüfspitze geschaltet und dieser mit einer entsprechenden Steuerspannung (oder einen entsprechenden Steuerstrom beim bipolar-Transistor) beaufschlagt, so dass dessen Kennlinie so festgelegt wird, dass der Transistor im Bereich zulässiger Messströme sich im Durchlassbereich befindet und durch den dann nur geringen Spannungsabfall die Prüfanordnung nicht wesentlich beeinflusst.

Übersteigt der Strom in der Zuleitung zur Prüfspitze den zulässigen Wert, so wird dieser nun durch den sich im Bereich des Sättigungsstromes befindlichen Transistor begrenzt. In der Literatur wird eine derartige Schaltung als Stromquelle bezeichnet. Um eine elektrische Beeinflussung der Prüfanordnung durch die Steuerspannung zu vermeiden, wird die Steuerspannung als galvanisch vom Rest der Prüfschaltung getrennte Spannungsversorgung ausgeführt. Dies kann z.B. durch Einsatz eines DC-DC Wandlers oder einer Batterie bzw. eines Akkumulators geschehen.

Die Erfindung bedient sich einer elektronischen Schutzschaltung zur Strombegrenzung einzelner Nadeln, die im Bereich zulässiger Ströme eine vernachlässigbare Änderung der elektrischen Eigenschaften des Messaufbaus verglichen mit einer Prüfkarte ohne derartige Schutzschaltung ergibt.

Diese Schutzschaltung der Erfindung hat beispielsweise folgende Eigenschaften:
1. Einsatz einer wie oben beschriebenen Stromquelle in der elektrischen Zuleitung zur Nadel, die im Bereich zulässiger Ströme niederohmig ist, bei Überlastströmen diesen jedoch begrenzt.
2. Galvanische Trennung der Stromquelle, die die Begrenzung in der elektrischen Zuleitung zur Prüfspitze vornimmt, und der Spannungsversorgung der Stromquelle selbst. Damit wird die eigentliche Mikrochip-Prüfschaltung nicht beeinflusst.

Weitere Einzelheiten und Merkmale der Erfindung ergeben sich aus der folgenden Beschreibung, in welchen auf die angeschlossene Zeichnung Bezug genommen wird.

Es zeigt:
Fig. 1 eine Ausführungsform einer erfindungsgemäßen Vorrichtung,
Fig. 2 ein Spannungsdiagramm, Fig. 3 ein Schaltungsbeispiel einer bidirektionalen Prüfnadel und Fig. 4 ein Schaltungsbeispiel mit zwei Prüfnadeln.

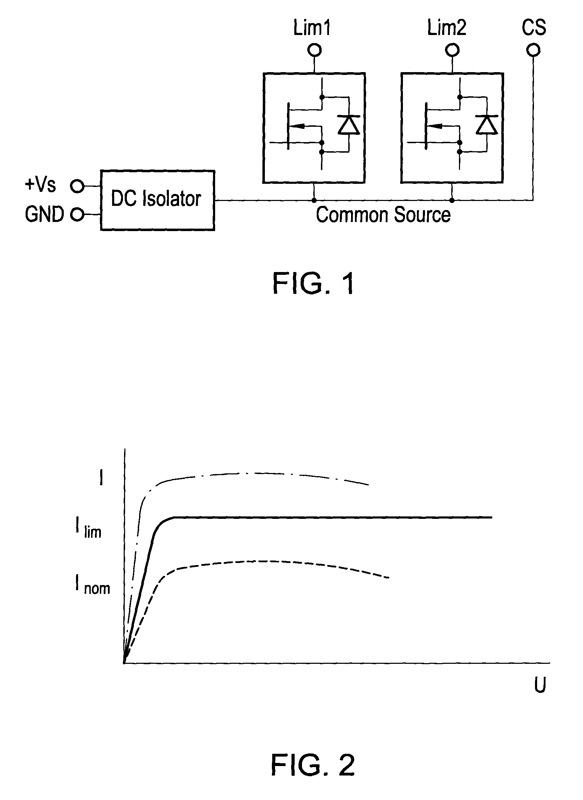

In einer bevorzugten Ausführungsform kann die zum Ausführen des erfahrungsgemäßen Verfahrens beispielsweise eingesetzte Vorrichtung zur aktiven Strombegrenzung, so wie in Fig. 1 gezeigt, ausgeführt sein.

In Fig. 1 bedeutet:
- V+:: positive Spannung
- Gnd:: GND Spannungszufuhr
- Lim1:: Strombegrenzer Anschluss 1
- Lim2:: Strombegrenzer Anschluss 2
- CS:: eine gemeinsame Stromquelle.

Die in Fig. 1 gezeigte Schaltung ergibt entweder eine bidirektionale Strombegrenzung (positive oder negative Polaritäten) für eine Prüfnadel zwischen Lim1 und Lim2 oder eine unidirektionale Begrenzung (eine Polarität je nach der Art der Schaltung) für zwei Nadeln (Lim1, Lim 2), die an eine Spannungsquelle (CS) angeschlossen sind.

In Fig. 2 ist in einem Stromspannungsdiagramm gezeigt, wie die elektrischen Eigenschaften der in Fig. 1 gezeigten Schaltung ausgebildet sind.

Beim normalen Betrieb, d.h. bei Stromwerten bis zu Iₙₒₘ verhält sich die Strombegrenzereinheit wie ein kleiner Widerstand. Wenn der Grenzstrom Iₗᵢₘ erreicht wird, begrenzt die Schaltung den Strom auf den eingestellten Wert. Die Spannungsversorgung für die Begrenzungseinheit ist galvanisch vom Strombegrenzungsweg getrennt.

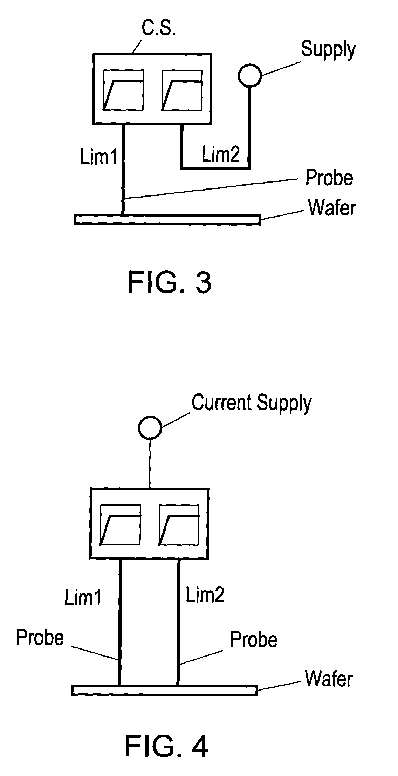

Im Falle einer bidirektionalen Schutz-(z.B. Stromzuführungs-)Prüfnadel kann die Anordnung wie in Fig. 3 gezeigt ausgeführt sein. In dieser Anordnung ist der Strom sowohl für die positive als auch für die negative Richtung des Stroms durch die Nadel begrenzt.

Bei der Variante der Schaltung gemäß Fig. 4 ist der Strom auf parallel geschaltete Prüfnadeln aufgeteilt und begrenzt. Diese Schaltung wird für Anwendungen verwendet, bei welchen der Prüfstrom höher ist als der maximale Strom für eine Prüfnadel und so auf mehrere Prüfnadeln aufgeteilt werden muss. Die Anwendung der erfindungsgemäßen Schaltung gewährleistet eine gleichmäßige Stromverteilung über die Nadeln nahezu unabhängig von sich ändernden Nadelkontaktwiderständen. Für mehr als zwei parallele Prüfnadeln können zusätzliche Schaltungen verwendet werden. Ein Beispiel hiefür ist in Fig. 4 gezeigt.

## Patentansprüche

1. Verfahren zum Begrenzen des Stroms beim Hochstromprüfen von Halbleiterbauelementen mit Prüfnadeln, **dadurch gekennzeichnet, dass** jeder Nadel eine Schaltung vorgeordnet wird, die im Bereich zulässiger Ströme niederohmig und oberhalb eines vorgegebenen Grenzstroms hochohmig ist, um den Strom zu begrenzen.

2. Verfahren nach Anspruch 1, **dadurch gekennzeichnet, dass** eine Schaltung verwendet wird, die wenigstens einen MOS-FET-Transistor oder wenigstens einen bipolaren Transistor enthält.

3. Verfahren nach Anspruch 1 oder 2, **dadurch gekennzeichnet, dass** die Stromquelle, welche die Begrenzung in der elektrischen Zuleitung zur Prüfspitze vornimmt, von der Spannungsversorgung der Stromquelle selbst galvanisch getrennt ist.

4. Schaltung zum Ausführen des Verfahrens nach einemd er Ansprüche 1 bis 3, **dadurch gekennzeichnet, dass** zwischen einer Stromquelle und/oder Prüfnadel ein Schaltungsbauteil angeordnet ist, der oberhalb eines vorgegebenen Grenzstroms hochohmig ist um die Größe des durch die Prüfnadel fließenden Stroms zu begrenzen.

5. Schaltung nach Anspruch 4, **dadurch gekennzeichnet, dass** der Schaltungsbauteil ein MOS-FET-Transistor oder ein bipolarer Transistor ist.

6. Schaltung nach Anspruch 4 oder 5, **dadurch gekennzeichnet, dass** die Stromquelle, welche die Begrenzung in der elektrischen Zuleitung zur Prüfspitze vornimmt, von der Spannungsversorgung der Stromquelle selbst galvanisch getrennt ist.
